# EUROPEAN PATENT APPLICATION

(11) **EP 1 833 161 A1**
(43) Date of publication of application: **12.09.2007**
(21) Application number: 07103382.3
(22) Date of filing: 02.03.2007
(51) Int. Cl.: H03F 1/32, H03F 3/21

(54) **Adaptive linear amplifier**

(30) Priority: 08.03.2006 KR 20060021796
(71) Applicant: Integrant Technologies Inc., Gyeonggi-do 463-810 (KR)
(72) Inventor: Kim, Tae Wook, Austin, 78759 (US); Yoo, Hee yong, Yongin-si Gyeonggi-do (KR); Kim, Bonkee, Seongnam-si Gyeonggi-do (KR); Jeong, Minsu, Anyang-si Gyeonggi-do (KR)
(74) Representative: Kastel, Stefan

(57) **Abstract**

The present invention relates to an amplifier and, more particularly, to an adaptive linear amplifier (200) with low power consumption and a high linearity. The adaptive linear amplifier (200) according to the present invention comprises amplification means (210) and a bias controller (230). The amplification means (210) comprises a main transistor (MN₂₁) and an auxiliary transistor unit (211). The main transistor (MN₂₁) and the auxiliary transistor unit (211) are coupled to each other. The bias controller (230) controls a bias Voltage applied to the main transistor (MN₂₁) and the auxiliary transistor unit (211).

## Description

This application claims priority on Patent Application No. 10-2006-0021796 filed in Republic of Korea on March 8, 2006, the entire contents of which are hereby incorporated by reference.

### BACKGROUND

### Field of the Invention

The present invention relates to an amplifier and, more particularly, to an adaptive linear amplifier with low power consumption and a high linearity.

### Discussion of Related Art

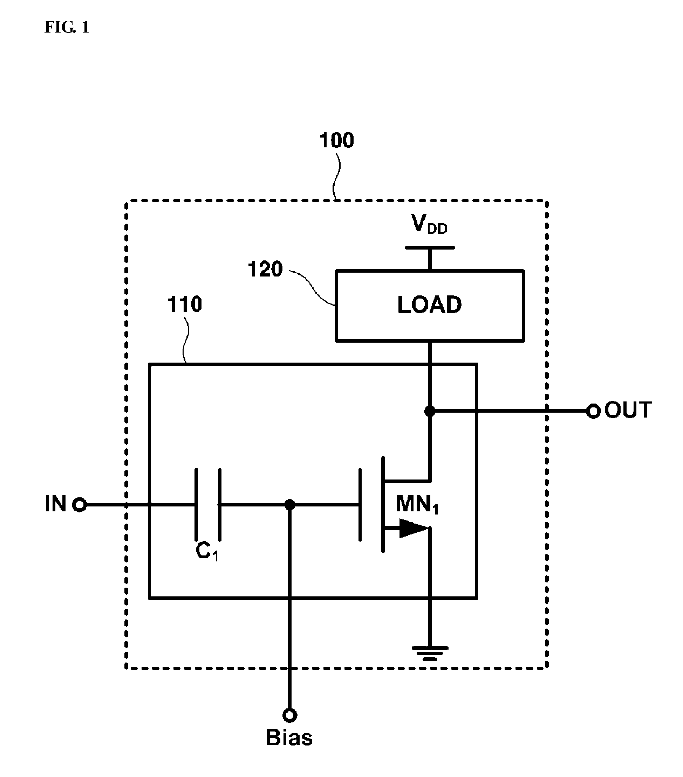

FIG. 1 is a circuit diagram of a conventional amplifier. As shown in FIG. 1, the conventional amplifier 100 has an amplification stage 110 and a load stage 120.

The amplification stage 110 has a transistor MN₁ and a capacitor C₁. A source terminal of the transistor MN₁ is grounded. The transistor MN₁ has a gate terminal connected to one terminal of the capacitor C₁. The capacitor C₁ has the other terminal connected to an input terminal IN. The transistor MN₁ has a drain terminal connected to one terminal of the load stage 120 and an output terminal OUT. The load stage 120 has the other terminal applied with a power supply voltage V_{DD}.

In the conventional amplifier 100, an input signal (that is, a small signal) is applied to the gate terminal of the transistor MN₁. In order to bias the transistor MN₁, a bias (that is, a large signal) is applied to the gate terminal of the transistor MN₁. Through this construction, the transistor MN₁ that is biased by the bias amplifies the input signal applied to the input terminal IN, and outputs an amplified signal to the output terminal OUT.

In the case where power control is performed by employing the amplifier 100, a bias point is changed in order to control the output power. However, such power control employing the amplifier 100 constructed above is disadvantageous in that only the amount of the output power is controlled and power consumption unnecessarily increases if the bias point is controlled in order to increase the output power.

### SUMMARY OF THE INVENTION

Accordingly, the present invention is to solve at least the problems and disadvantages of the background art, and provides an amplifier capable of changing an output power region.

The present invention further provides an amplifier with reduced power consumption and a high linearity.

An adaptive linear amplifier according to an embodiment of the present invention comprises amplification means and a bias controller. The amplification means comprises a main transistor and an auxiliary transistor unit. The main transistor and the auxiliary transistor unit are coupled to each other. The bias controller controls a bias voltage applied to the main transistor and the auxiliary transistor unit.

The main transistor and the auxiliary transistor unit may be coupled in parallel.

The auxiliary transistor unit may comprise a first auxiliary transistor and a second auxiliary transistor. The first auxiliary transistor and the second auxiliary transistor may be coupled in parallel.

The bias controller may generate the bias voltage with reference to a Look Up Table (LUT).

The LUT may comprise bias data for a low output power and bias data for a high output power.

The main transistor may operate in a saturation region, and the auxiliary transistor unit may operate in a sub-threshold region.

### BRIEF DESCRIPTION OF THE DRAWINGS

FIG. 1 is a circuit diagram of a conventional amplifier;

FIG. 2 is a circuit diagram of an adaptive linear amplifier according to an embodiment of the present invention; and

FIG. 3 is a graph showing output power regions of the adaptive linear amplifier according to an embodiment of the present invention.

### DETAILED DESCRIPTION OF PREFERRED EMBODIMENTS

The present invention will now be described in detail in connection with a specific embodiment with reference to the accompanying drawings.

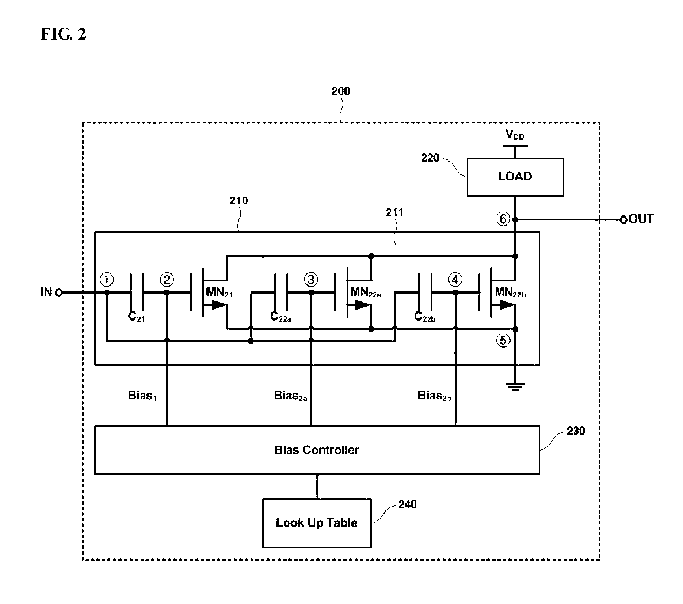

FIG. 2 is a circuit diagram of an adaptive linear amplifier 200 according to an embodiment of the present invention.

As shown in FIG. 2, the adaptive linear amplifier 200 according to an embodiment of the present invention comprises amplification means 210, a load stage 220, a bias controller 230, and a LUT(Look Up Table) 240.

The amplification means 210 comprises a main transistor MN₂₁ and an auxiliary transistor unit 211. A signal input terminal of the main transistor MN₂₁ comprises a main capacitor C₂₁. The auxiliary transistor unit 211 comprises a first auxiliary transistor MN₂₂ₐ, a first auxiliary capacitor C₂₂ₐ, a second auxiliary transistor MN_{22b}, and a second auxiliary capacitor C_{22b}.

An input terminal IN is connected to a first node 1. The main capacitor C₂₁ has one terminal connected to the first node 1 and the other terminal connected to a second node 2. The main transistor MN₂₁ has a signal input terminal (a gate terminal) connected to the second node 2. One terminal (a drain terminal) of a main current path of the main transistor MN₂₁ is connected to a sixth node 6. The other terminal (a source terminal) of the main current path of the main transistor MN₂₁ is connected to a fifth node 5

The first auxiliary capacitor C₂₂ₐ has one terminal connected to the first node 1 and the other terminal connected to a third node 3.

The first auxiliary transistor MN₂₂ₐ has a signal input terminal (a gate terminal) connected to the third node 3. One terminal (a drain terminal) of a main current path of the first auxiliary transistor MN₂₂ₐ is connected to the sixth node 6. The other terminal (a source terminal) of the main current path of the first auxiliary transistor MN₂₂ₐ is connected to the fifth node 5.

The second auxiliary capacitor C_{22b} has one terminal connected to the first node 1 and the other terminal connected to a fourth node 4.

The second auxiliary transistor MN_{22b} has a signal input terminal (a gate terminal) connected to the fourth node 4. One terminal (a drain terminal) of a main current path of the second auxiliary transistor MN_{22b} is connected to the sixth node 6. The other terminal (a source terminal) of the main current path of the second auxiliary transistor MN_{22b} is connected to the fifth node 5.

The load stage 220 has a power supply terminal applied with a power supply voltage V_{DD}. The load stage 220 has the output terminal connected to the sixth node 6 and an output terminal OUT. The fifth node 5 is grounded (GND).

The bias controller 230 has a main control terminal connected to the second node 2, a first auxiliary control terminal connected to the third node 3, and a second auxiliary control terminal connected to the fourth node 4.

The main capacitor C₂₁, the first auxiliary capacitor C₂₂ₐ, and the second auxiliary capacitor C_{22b} serve to block the DC component of the input signal applied to the input terminal IN. The main transistor MN₂₁ amplifies an input signal applied to the input terminal IN, and outputs an amplified signal to the output terminal OUT.

Such properties as a channel width function and a channel size of the main transistor MN₂₁ are decided during a manufacturing process. The main transistor MN₂₁ is biased (Bias₁) by the bias controller 230 such that it operates in a saturation region. The main transistor MN₂₁ has a poor linearity since it has a constant amount of gm". gm' has a negative polarity.

In order to reduce the influence of gm" of the main transistor MN₂₁ on the linearity, gm" of the first auxiliary transistor MN₂₂ₐ and the second auxiliary transistor MN_{22b} are made to have a positive polarity, thus offsetting gm" of the main transistor MN₂₁ having a negative polarity.

Such properties as a channel width function and a channel size of the first auxiliary transistor MN₂₂ₐ and the second auxiliary transistor MN_{22b} are decided during a manufacturing process. The first auxiliary transistor MN₂₂ₐ and the second auxiliary transistor MN_{22b} are biased (Bias₂ₐ, Bias_{2b}) by the bias controller 230 such that they operate in a sub-threshold region.

The bias controller 230 decides the bias amount of each of the main transistor MN₂₁, the first auxiliary transistor MN₂₂ₐ, and the second auxiliary transistor MN_{22b} with reference to the LUT 240.

The LUT 240 comprises bias data for a low output power and bias data for a high output power, and allows a bias depending on a condition of the output power to be applied. A width function and an offset bias value are properly controlled such that the first auxiliary transistor MN₂₂ₐ and the second auxiliary transistor MN_{22b} have gm" of a negative region.

Through this construction, IMD3 (3-order Intermodulation Distortion), which is generated when an input signal is amplified by the main transistor MN₂₁, can be reduced by the first auxiliary transistor MN₂₂ₐ and the second auxiliary transistor MN_{22b}.

Further, the transconductance of the first auxiliary transistor MN₂₂ₐ and the second auxiliary transistor MN_{22b} is changed by the bias controller 230, and the value gm" of the main transistor MN₂₁ and the values gm" of the first auxiliary transistor MN₂₂ₐ and the second auxiliary transistor MN_{22b} are changed, so that the region of the output power is changed.

If the bias points of the main transistor MN₂₁, the first auxiliary transistor MN₂₂ₐ, and the second auxiliary transistor MN_{22b} are changed, the output power region of the adaptive linear amplifier 200 according to an embodiment of the present invention can be changed, reducing power consumption and improving the linearity.

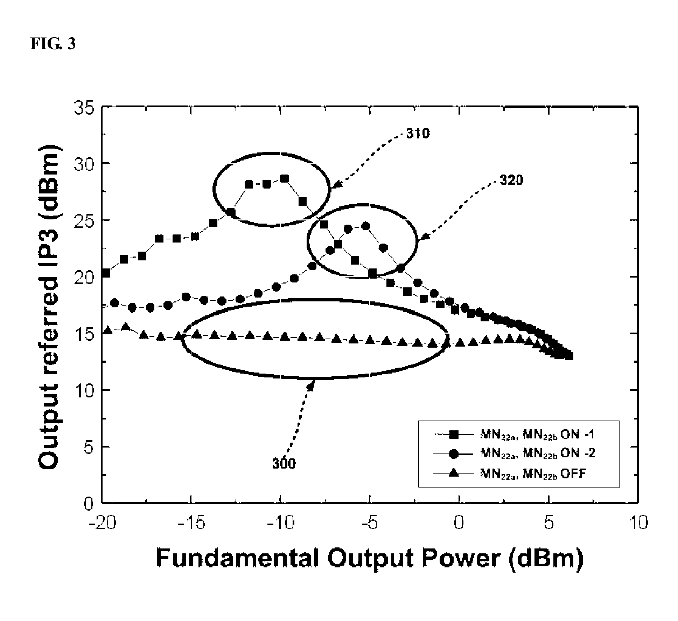

FIG. 3 is a graph showing output power regions of the adaptive linear amplifier according to an embodiment of the present invention.

As illustrated in FIG. 3, the graph showing the output power region of the amplifier according to an embodiment of the present invention comprises three types of biasing states.

A first region 300 is a region regarding the output power of only the main transistor MN₂₁, which is biased by the bias controller 230, and IP3. In this region, the output power is controlled by changing the bias point as in the prior art.

A second region 310 and a third region 320 are regions regarding the output powers of the main transistor MN₂₁, the first auxiliary transistor MN₂₂ₐ, and the second auxiliary transistor MN_{22b}, which are biased by the bias controller 230, and IP3.

The second region 310 is useful when an input signal needs to be amplified and a relatively low output power is required, while improving the linearity and minimizing power consumption, of the adaptive linear amplifier 200 according to an embodiment of the present invention.

The third region 310 is useful when an input signal needs to be amplified and a relatively high output power is required, while improving the linearity and minimizing power consumption, of the adaptive linear amplifier 200 according to an embodiment of the present invention.

Through this construction, if the bias controller 230 controls the biasing of the main transistor MN₂₁, the first auxiliary transistor MN₂₂ₐ, and the second auxiliary transistor MN_{22b} to be different depending on the amount of the output power by reference to the LUT, an amplifier with a high linearity and low power consumption can be fabricated.

As described above, the present invention is advantageous in that it can change the output power region of an amplifier.

Furthermore, the present invention is advantageous in that it can reduce power consumption and improve the linearity, of an amplifier.

While the invention has been described in connection with what is presently considered to be a practical exemplary embodiment, it is to be understood that the invention is not limited to the disclosed embodiment, but, on the contrary, is intended to cover various modifications and equivalent arrangements included within the spirit and scope of the appended claims.

## Claims

1. An adaptive linear amplifier (200), comprising:
amplification means (210) comprising a main transistor (MN₂₁) and an auxiliary transistor unit (211), the main transistor (MN₂₁) and the auxiliary transistor unit (211) being coupled to each other; and
a bias controller (230) for controlling a bias voltage applied to the main transistor (MN₂₁) and the auxiliary transistor unit (211).

2. The adaptive linear amplifier of claim 1, wherein the main transistor (MN₂₁) and the auxiliary transistor unit (211) are coupled in parallel.

3. The adaptive linear amplifier of claim 1 or claim 2, wherein:
the auxiliary transistor unit (211) comprises a first auxiliary transistor (MN₂₂ₐ) and a second auxiliary transistor (MN_{22b}), and
the first auxiliary transistor (MN₂₂ₐ) and the second auxiliary transistor (MN_{22b}) are coupled in parallel.

4. The adaptive linear amplifier of any of the claims 1 to 3, wherein the bias controller (230) generates the bias voltage with reference to a Look Up Table (LUT) (240).

5. The adaptive linear amplifier of claim 4, wherein the LUT (240) comprises bias data for a low output power and bias data for a high output power.

6. The adaptive linear amplifier of any of the claims 1 to 5, wherein:
the main transistor (MN₂₁) operates in a saturation region, and
the auxiliary transistor unit (211) operates in a sub-threshold region.
